Europäisches Patentamt

European Patent Office

Office européen des brevets

(11) Publication number: **0 397 929**
**A1**

# (12) EUROPEAN PATENT APPLICATION

(21) Application number: **89201258.4**

(22) Date of filing: **17.05.89**

(51) Int. Cl.5: **H05K 3/34, B23K 1/08, B23K 1/20**

The title of the invention has been amended (Guidelines for Examination in the EPO, A-III, 7.3).

(43) Date of publication of application:
**22.11.90 Bulletin 90/47**

(84) Designated Contracting States:
**DE FR GB IT NL**

(71) Applicant: **SOLTEC B.V.**
**Karolusstraat 20**
**NL-4903 RJ Oosterhout(NL)**

(72) Inventor: **Schouten, Gerrit**
**Sirius 46**
**NL-4907 CK Oosterhout(NL)**

(74) Representative: **Hoorweg, Petrus Nicolaas et al**
**OCTROOIBUREAU ARNOLD & SIEDSMA**
**Sweelinckplein 1**
**NL-2517 GK The Hague(NL)**

(54) **Printed circuit board with improved soldering qualities.**

(57) The invention relates to the soldering of printed circuit boards. To avoid the prior art difficulties encountered with the limited effectiveness of reduction agents, the reduction agent is applied such that it is active until the end of the soldering process. By applying the reduction agent on the printed circuit board (1) before the soldering process, the active period of said agent is extended, in that it is not flushed away easily. By applying said reduction agent (10) in cavities (9) provided in the layer of protective lacquer (6) of the printed circuit board (1), this period is even extended further. According to a preferred embodiment, those cavities (9) also comprise the soldering flux.

FIG. 2

EP 0 397 929 A1

## PRINTED CIRCUIT BOARD WITH IMPROVED SOLDERING QUALITIES

The present invention relates to a soldering process, in which a printed circuit board is conveyed with its face to be soldered through liquid solder, and in which a reduction agent for the solder is active, and it further relates to a printed circuit board to be used with said process.

Such printed circuit boards are generally known.

When such printed circuit boards have been provided with components on their component face, they are conveyed with their lower face through a soldering bath to solder the wires of the components to the soldering areas of the printed circuit boards. Recently, these soldering processes are more often executed with the help of so called wave soldering machines, in which the printed circuit board is conveyed over the top of a soldering wave.

To improve the soldering process the face of the printed circuit board to be soldered is provided with a layer of soldering flux. This soldering flux serves for the cleaning of the copper areas to be soldered, so that the adherence of the solder to the copper of the soldering areas and the material of the component wires respectively is improved, so that soldering connections with a good quality are obtained. Further the soldering flux comprises a reduction agent to remove oxides and pollutions developping on the surface of the liquid solder. These pollutions generally tend to enlarge the surface tension of the liquid solder, so that at the separation of the printed circuit board from the solder vessel so called solder bridges can develop, which result in undesired connections and hence cause short circuits. This disadvantage is alliviated by the reduction agent.

In such soldering processes, in particular in the case of wave soldering, the danger develops that the reduc tion agent is carried away by the flow of the soldering wave before this agent has executed its task. The result is that the surface of the soldering wave is not free of oxides, so that bridges and short circuits develop.

The aim of the present invention is to provide means, which avoids the disadvantages set out above.

This aim is reached, in that the reduction agent continues to be active on the printed circuit board until at least at the end of the soldering process.

Thus it is avoided that the reduction agent is off-by the flushed soldering wave, so that it continues to be active during the whole process, soldering connections with a good quality are obtained, and the development of bridges is avoided.

Subsequently, the present invention will be elucidated with the help of an embodiment shown in the drawings. In the drawings show:

fig. 1: a schematic cross-sectional view of a printed circuit board according to the prior art;

fig. 2: a schematic cross-sectional view of a printed circuit board according to the priort art, in which this printed circuit board is being processed to obtain a printed circuit board according to the present invention;

fig. 3: a schematic cross-sectional view of a printed circuit board during the soldering process;

fig. 4: a schematic cross-sectional view of a printed circuit board, which has been soldered according to the present invention; and

fig. 5: a view of a printed circuit board according to the present invention before the start of the soldering process.

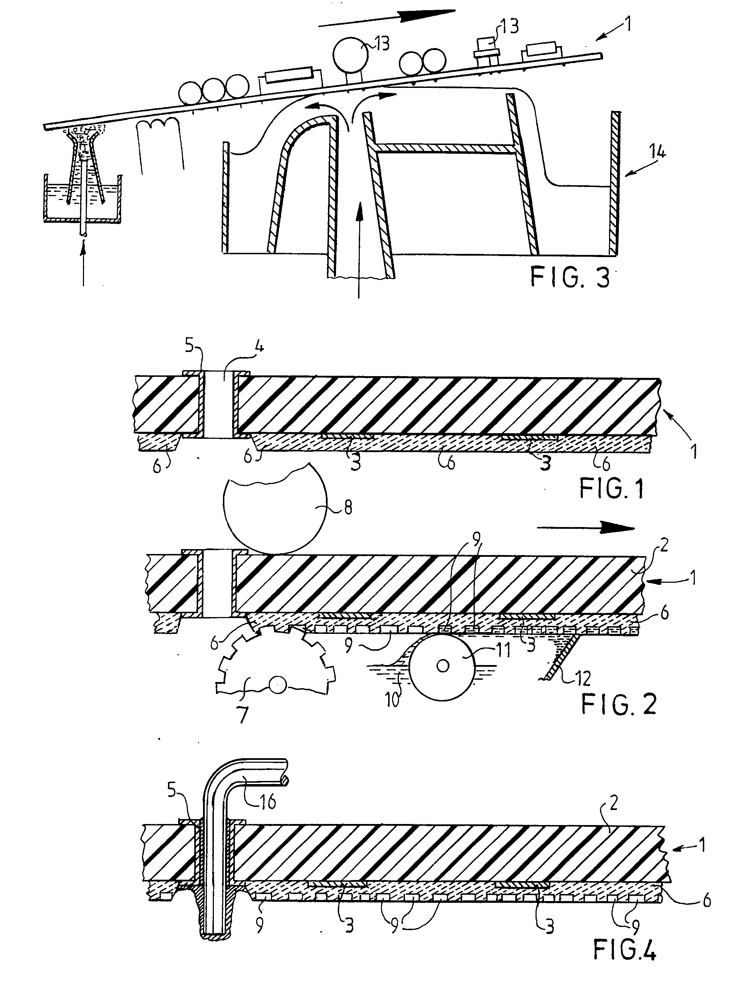

The printed circuit board 1 shown in fig. 1 comprises a board 2 of insulating material, on one face thereof paths 3 prepared of conducting material have been provided, which paths form the circuit to be realised together with the components to be applied on the printed circuit board. Generally the components are provided at that face of the board 2, onto which no conducting paths have been provided. To connect the components with the paths holes 4 are drilled in the printed circuit board, through which the wires of the components extend.

Of course it is also possible to apply the present invention in so called double printed circuit boards, in which both faces of the printed circuit board have been provided of copper paths. In that case as well the components generally have been applied to one side only.

In the present example such a hole 4 is provided with bush 5 prepared of conducting material. Such a bush, which is firmly connected with the copper paths on both sides improves the contact between the wire of the component and the soldering areas by enlarging the contact surface. Such bushes or completely metallised holes, which are often applied in the case of double-sided printed circuit boards are, however, not necessary for the present invention.

The printed circuit boards to be soldered with the help of a soldering machine are provided with a protective lacquer with the exception of the areas to be soldered. Thus only the parts to be soldered are covered with a layer of solder after the later conveyance of the printed circuit boards through the soldering bath. In fig. 1 the layers of protective lacquer have been indicated with 6. Normally, the face to be soldered is provided with a layer of soldering flux to improve the quality of the soldering connection obtained. However, this only takes place shortly before the soldering in the soldering machine.

According to the present invention beforehand and even before the applying of the components, the face to be soldered of the printed circuit board is provided with a reduction agent, and such that the reduction agent continues to be active during the whole period of the soldering process. This is achieved by providing the reduction agent in cavities, which have been provided in the face to be soldered of the printed circuit board, and, as is shown in the present embodiment, only in the layer of protective lacquer 6.

To achieve this, the printed circuit board 1 is conveyed through an apparatus, which, as is depicted in fig. 2, provides cavities in the strips of protective layer 6, which apparatus comprises a toothed roller 7 and a counter roller 8 provided at the other side of the printed circuit board. The toothed roller impresses a chess board like pattern of cavities in the relatively soft layer of protective lacquer 6, so that this layer is provided of a large number of small cavities 9.

Subsequently the printed circuit board passes an apparatus for the applying of the reduction agent, which, in the present embodiment comprises a roller 11, which is partially dipped in a bath of reduction agent 10, which roller picks up the reduction agent 10 and applies it in the cavities 9. After that a levelling knife 12 has been provided, which removes superfluous reduction agent.

Said pattern can, besides, also be obtained by applying the layer of protective lacquer in a pattern by means of screen printing. The cavities thus developped are filled with reduction agent, in the way which is described with the help of fig. 2 or in another way.

The resulting printed circuit board is then, after the provision of the relevant components fit to be soldered, as is depicted in fig. 3.

Herein the printed circuit board 1, which in the meantime has been provided of components 13, passes an apparatus 15 for provision of a layer of soldering flux under the printed circuit board. Such apparatusses are well known in this field of engineering, so that it is not further described. Subsequently the printed circuit board 1 passes a drying apparatus 16, in which the soldering flux is being dried, so that the lower surface of the printed circuit board 1 is provided with a dried layer of soldering flux. In the present embodiment the drying apparatus is comprised of a heating element.

Subsequently the printed circuit board 1 is conveyed through a soldering machine 15, in which all areas to be soldered, and which have not been sealed of by means of the layer of protective lacquer are provided with a layer of solder, so that all wires of the components 13 are being fixed. In particular in the case of wave soldering machines, the danger develops that the soldering flux is carried away in both directions with the solder flowing, so that this soldering flux is flushed off before the soldering flux has been effective. By the features of the present invention this danger is avoided, so that the soldering flux can perform its task completely.

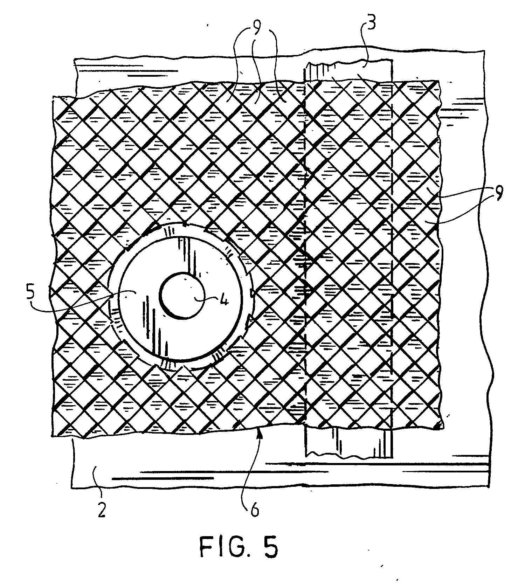

After the processing of the printed circuit board 1 by the soldering machine, the printed circuit board develops as is depicted in fig. 4. On all locations 3 to be soldered a layer of solder 15 has been provided, which provides a good contact between the relevant wire 16 of the component and the soldering area 3, and the copper bush 5 respectively. The reduction agent 10 possibly remained back in the cavities can be removed with a separate treatment.

Fig. 5 shows a bottom view of the printed circuit board 1 onto which the chess board pattern of the cavities 9, in which the reduction agent has been provided, are clearly shown.

In this connection the remark is made, that the reduction agent, that beforehand often was a component of the soldering flux, is supplied separately so that this has not to be incorporated into the soldering flux.

## Claims

1. Soldering process, in which a printed circuit board with its face to be soldered, is conveyed through liquid solder and in which a reduction agent for the solder is active, **characterized in** that the reduction agent is active until at least the end of the soldering process.

2. Soldering process according to claim 1, **characterized in** that het reduction agent for the solder also has a protective working.

3. Soldering process according to claim 1 or 2, **characterized in** that the reduction agent is present on the printed circuit board at the start of the soldering process.

4. Printed circuit board to be soldered with the soldering process according to one of the claims 1, 2 or 3, **characterized in** that the reduction agent has been applied such on the printed circuit board, that the reduction agent continues to be active until at least the end of the soldering process.

5. Printed circuit board according to claim 4, **characterized in** that the reduction agent continues to be present until at least the end of the soldering process.

6. Printed circuit board according to one of the claims 4 or 5, provided with a layer of protective lacquer protecting the solder, **characterized in** that the reduction agent has been applied on the protective lacquer.

7. Printed circuit board according to one of the claims 4, 5 or 6, **characterized in** that the outer layer of the face of the printed circuit board to be soldered has at least partially been provided with cavities in which the reduction agent has been applied.

8. Printed circuit board according to claim 7, **characterized in** that the protective lacquer protecting the solder, applied at the face to be soldered of the printed circuit board comprises cavities for the soldering flux.

9. Printed circuit board according to claim 7 or 8, **characterized in** that the cavities have been provided according to a grid pattern.

10. Printed circuit board according to claim 9, **characterized in** that the cavities have been provided according to a chess board pattern.

FIG. 3

FIG. 1

FIG. 2

FIG.4

EP 0 397 929 A1

FIG. 5

13303-4.

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | US-A-4 429 457 (NOGUCHI et al.) <br> * Column 1, line 43 - column 2, line 7; column 3, line 62 - column 4, line 20 * | 1-4 | H 05 K 3/34 <br> B 23 K 1/08 <br> B 23 K 1/20 |
| X | GB-A-2 174 326 (ASAHI CHEMICAL RESEARCH LABORATORY CO.) <br> * Page 1, lines 8-17; page 1, line 46 - page 2, line 17 * | 1,3-5 | |
| X | TOUTE L'ELECTRONIQUE, no. 516, September 1986, pages 54-63, Paris, FR: "Technologie du montage en surface des composants: Les procedes de montages et de brasure" <br> * Page 60, paragraphs "Les Flux" and "L'application du flux" * | 1,3-5 | |
| X | US-A-4 538 757 (BERTIGER) <br> * Abstract * | 1,2,5 | |
| A | EP-A-0 285 701 (NIPPON CMK CORP.) <br> * Claims * | 1,3-5 | TECHNICAL FIELDS SEARCHED (Int. Cl.5) |
| A | EP-A-0 131 730 (LGZ LANDIS & GYR ZUG AG) <br> * Page 1, lines 4-34; claim 1 * | 1,5 | H 05 K <br> B 23 K |

The present search report has been drawn up for all claims

| Place of search | Date of completion of the search | Examiner |
|---|---|---|
| THE HAGUE | 10-01-1990 | MES L.A. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)